# EUROPÄISCHE PATENTSCHRIFT

(11) **EP 0 890 108 B1**
(45) Veröffentlichungstag und Bekanntmachung des Hinweises auf die Patenterteilung: **25.10.2000**
(21) Anmeldenummer: 97916375.5
(22) Anmeldetag: 21.03.1997
(51) Int. Cl.: G01R 29/08

(54) **FELDSENSOR UND VORRICHTUNG SOWIE VERWENDUNG DER VORRICHTUNG ZUR MESSUNG ELEKTRISCHER UND/ODER MAGNETISCHER FELDER**
FIELD SENSOR AND DEVICE AND USE OF THE DEVICE FOR MEASURING ELECTRIC AND/OR MAGNETIC FIELDS
CAPTEUR DE CHAMP, ET DISPOSITIF ET UTILISATION DU DISPOSITIF POUR MESURER LES CHAMPS ELECTRIQUES ET/OU MAGNETIQUES

(30) Priorität: 29.03.1996 DE 19612777; 19.11.1996 DE 19647830
(43) Veröffentlichungstag der Anmeldung: 13.01.1999
(73) Patentinhaber: Maschek, Hubertus, 86916 Kaufering (DE)
(72) Erfinder: Maschek, Hubertus, 86916 Kaufering (DE)
(74) Vertreter: VOSSIUS & PARTNER
(86) Internationale Anmeldenummer: EP9701453
(87) Internationale Veröffentlichungsnummer: WO9737233

(56) Entgegenhaltungen:
- DE-A- 4 428 336
- US-A- 4 588 993
- POLIVKA J I: "RADIATION DETECTOR" ELECTRONICS WORLD AND WIRELESS WORLD, Bd. 100, Nr. 1695, 1.Februar 1994, Seite 148 XP000426426
- ALASDAIR PHILIPS: "MEASURING MAGNETIC FIELDS IN YOUR OWN HOME" ELECTRONICS WORLD AND WIRELESS WORLD, Bd. 97, Nr. 1673, 1.April 1992, Seiten 281-283, XP000282129
- PURANEN L ET AL: "SIMULTANEOUS MEASUREMENTS OF RF ELECTRIC AND MAGNETIC NEAR FIELDS THEORETICAL CONSIDERATIONS" IEEE TRANSACTIONS ON INSTRUMENTATION AND MEASUREMENT, Bd. 42, Nr. 6, 1.Dezember 1993, Seiten 1001-1008, XP000418720
- TANDLER D: "DREIDIMENSIONALE ANALYSE ELEKTRISCHER UND MAGNETISCHER FELDER" NTZ NACHRICHTENTECHNISCHE ZEITSCHRIFT, Bd. 48, Nr. 12, 1.Dezember 1995, Seiten 26-28, XP000552040
- S.CHAUZY: "Mise au point d'un mesureur de champ électrique alternatif 50 HZ" REVUE G N RALE DE L'ELECTRICIT , Nr. 7, Juli 1988, PARIS, Seiten 27-38, XP002041460
- HIRSCH H: "NETZUNABHAENGIGES, POTENTIALFREIES FELDMESSSYSTEM FUER TECHNISCHE FREQUENZEN" TECHNISCHES MESSEN TM 1982 - 1988 INCOMPLETE, Bd. 57, Nr. 12, 1.Dezember 1990, Seiten 473-477, XP000177814
- RAMIREZ-NINO J ET AL: "A DEVICE FOR THE X-Y MEASUREMENT OF ELECTRIC FIELDS" MEASUREMENT SCIENCE AND TECHNOLOGY, Bd. 5, Nr. 12, 1.Dezember 1994, Seiten 1436-1442, XP000493665

## Beschreibung

Die Erfindung bezieht sich auf einen Feldsensor mit Einrichtungen zum Messen eines magnetischen Feldes und/oder eines elektrischen Feldes sowie ein entsprechendes Verfahren.

US-A-4 588 993 zeigt einen Feldsensor gemäß dem Oberbegriff des Anspruchs 1. DE-A-4 428 336 zeigt bereits eine Vorrichtung zum Messen elektrischer Felder, die sechs Kondensatorplatten aufweist, welche würfelförmig angeordnet sind.

Der Erfindung liegt die Aufgabe zugrunde, einen Feldsensor der genannten Art zu schaffen, mit dem gleichzeitig oder nacheinander elektrische und magnetische Felder in beliebiger Richtung gemessen werden können und eine zugehörige Vorrichtung sowie ein entsprechendes Verfahren bereitzustellen.

Diese Aufgabe wird mit den Merkmalen des Anspruchs 1 gelöst.

Die Ansprüche 32 und 35 betreffen die Verwendung einer Vorrichtung. Die Ansprüche 2-31 und 33-34 betreffen vorteilhafte Ausgestaltungen.

Bei einem Feldsensor sind wenigstens sechs Kondensatorplatten vorgesehen, welche würfelartig angeordnet sind, und in dem dadurch gebildeten Raum die Einrichtung zum Messen des magnetischen Feldes vorgesehen ist, die dreidimensional ausgerichtet ist und beispielsweise aus Spulen, Halleffektsensoren, Feldplatten oder dergleichen besteht.

Die Kondensatorplatten dienen dabei dazu, das elektrische Feld dreidimensional zu messen und erzeugen gleichzeitig im Innern ihrer räumlichen Anordnung einen feldfreien Raum. In diesem ist dann die Einrichtung zum Messen angeordnet, die unbeeinflußt vom elektrischen Feld eine dreidimensionale Erfassung des Magnetfeldes ermöglicht. Somit ist erreicht, daß gleichzeitig, aber ohne gegenseitige Beeinflussung, ein elektrisches und ein magnetisches Feld dreidimensional erfaßt werden.

Bei einer vorteilhaften Ausgestaltung der Erfindung ist vorgesehen, daß drei ring- bzw. zylinderförmig gewickelte Spulen vorgesehen sind, die jeweils in der X-, Y- bzw. Z-Achse angeordnet sind, und daß die Spulen von den Kondensator-Platten umgeben sind, von denen jeweils zwei parallel zueinander angeordnet sind.

Gemäß einer alternativen Ausführungsform sind die Kondensator-Platten teilweise oder vollständig innerhalb einer Raumes angeordnet, der von den Elementen einer Magnetfeldmeßeinrichtung gebildet wird. Bei dem Beispiel einer Magnetfeldmeßeinrichtung, die aus Spulen besteht, ragen dabei die Spulen teilweise oder vollständig über die Kondensator-Platten hinaus. Die Größe der Kondensator-Platten und deren Abstand zueinander wird dabei im Verhältnis zur Größe der Elemente der Magnetfeldmeßeinrichtung so gewählt, daß ein elektrisches und magnetisches Feld dreidimensional gleichzeitig erfaßt werden kann, wobei eine gegenseitige Beeinflussung vorzugsweise gering ist. Vorzugsweise ist die Kantenlänge der Kondensator-Platten klein im Verhältnis zu den äußeren Abmessungen der Elemente der Magnetfeldmeßeinrichtung. Das Verhältnis zwischen der Kantenlänge der Kondensator-Platten und beispielsweise einem Durchmesser einer Magnetfeldspule liegt im Bereich von 1 zu 100 bis 100 zu 1. Die Kondensator-Platten können bis zu 30% des Spulendurchmessers nach innen versetzt angeordnet sein.

Mit anderen Worten sind bei den alternativen Ausführungsformen der von den Kondensator-Platten gebildete Raum und der von der Einrichtung zum Messen des magnetischen Feldes gebildete Raum zueinander ausgerichtet, wobei sich beide Systeme räumlich durchdringen mit einem gemeinsamen Bezugspunkt.

Eine weitere vorteilhafte Ausgestaltung der Erfindung liegt darin, daß die Spulen ringförmig mit nahezu gleichem Durchmesser ineinander angeordnet sind.

Damit ist eine gleichmäßige Erfassung des Magnetfeldes in allen drei Richtungen erreicht.

Als ebenfalls sehr vorteilhaft hat es sich erwiesen, wenn gemäß einer weiteren Ausgestaltung der Erfindung jeweils einer Spule ein Kondensator-Plattenpaar zugeordnet ist, die parallel zur jeweiligen Spule außerhalb der Spulenanordnung vorgesehen sind.

Damit wird eine einwandfreie Abschirmung der Spulen durch die Kondensatorplatten erzielt.

Sehr günstig ist es auch, wenn entsprechend einer erfindungsgemäßen Ausgestaltung die Kondensatorplatten mit einer hochohmigen Beschichtung versehen sind.

Es ist aber auch möglich, daß gemäß einer weiteren Ausgestaltung der Erfindung die Kondensatorplatten aus einem hochohmigen Material bestehen.

Mit beiden Ausgestaltungen wird eine Beeinflussung des zu messenden magnetischen Feldes ausgeschlossen.

Eine weitere erfindungsgemäße Ausgestaltung ist dadurch gekennzeichnet, daß die Kondensatorplatten doppelt angeordnet sind, wobei die jeweils innere Platte elektrisch an einem gemeinsamen Masseanschluß liegt.

Hierdurch wird eine Beeinflussung des elektrischen Feldes durch die Spulen, Halleffektsensoren oder Feldplatten ausgeschlossen.

Als ebenfalls sehr vorteilhaft hat es sich erwiesen, wenn gemäß einer weiteren Ausgestaltung der Erfindung die elektrischen Anschlüsse der Kondensatorplatten an deren Rand vorgesehen sind. Dadurch wird eine Beeinflussung des Meßergebnisses durch den in den Anschlußleitungen fließenden Strom vermieden.

Die vorliegende Erfindung betrifft weiter eine Vorrichtung zur Messung elektrischer Felder, die einen Feldsensor mit mindestens einem Kondensator-Plattenpaar aufweist, dessen Ausgangsspannungen an den nicht-invertierenden und invertierenden Eingang eines Differenzverstärkers angelegt wird, wobei zwischen den beiden Eingängen des Differenzverstärkers ein Kondensator angeschlossen ist. Diese Meßvorrichtung ist insbesondere mit dem vorstehend beschriebenen Feldsensor verwendbar. Die Meßvorrichtung arbeitet nach folgendem Grundprinzip. Eine Anordnung von zwei Kondensatorplatten verursacht im elektrischen Feld am Kondensator einen Spannungsabfall, der über einen Differenzverstärker vorzugsweise hochohmig und vorzugsweise mit kleiner Eingangskapazität gegen Masse entkoppelt wird. Durch einen relativ hohen Strom durch den Kondensator wird die Einkopplung von Störspannungen von Seite des Meßverstärkers sowie die Feldstärke zwischen den Kondensatorplatten minimiert. Die Meßvorrichtung ist bevorzugt einsetzbar zur Messung von elektrischen und/oder magnetischen Feldern mit einer Frequenz von 1 Hz bis 30 GHz, besonders bevorzugt 5 Hz bis 400 kHz. Die Meßvorrichtung hat insbesondere den Vorteil, daß sie als Handgerät ausgeführt werden kann, mit dem sowohl stationär als auch in Bewegung mit elektrisch leitfähigen Ableitungen gemessen werden kann, wobei die daraus resultierenden Meßfehler minimiert werden.

Ein weiteres bevorzugtes Merkmal ist die Verwendung dünner Drähte, zur Verbindung zwischen der Meßvorrichtung und dem Kondensatorplattenpaar. Dies hat den Vorteil, daß aufgrund des geringen Querschnitts der Drähte eine Feldbeeinflussung im Verhältnis zu der Plattengröße des Kondensatorplattenpaares gering ist.

Bevorzugt werden jeweils zwei Drähte zur Verbindung mit einem Kondensatorplattenpaar miteinander verdrillt. Dadurch werden infolge eines Stromes in den Drähten entstehende Magnetfelder gegenseitig aufgehoben und damit das resultierende Magnetfeld gering gehalten, sowie ein umgekehrter Effekt verringert.

Vorzugsweise ist der Abstand zwischen den Feldplatten und dem Meßverstärker so groß, daß eine Beeinflussung des zu messenden elektrischen Feldes durch die Meßvorrichtung gering ist.

Besonders bevorzugt ist, daß die Fläche des Kondensators und des Kondensators und des Differenzverstärkers jeweils klein ist gegenüber der Fläche der Kondensatorplatten, um eine Beeinflussung des zu messenden elektrischen Feldes durch die Meßvorrichtung weiter zu vermeiden. Das erfindungsgemäße Verfahren zur Messung elektrischer und/oder magnetischer Felder wird vorzugsweise mit einer Kombination des vorstehend beschriebenen Feldsensors und der zugehörigen Meßvorrichtung durchgeführt. Insbesondere können mit dem Verfahren Meßfehler, die durch die messende Person oder die elektrische Ableitung entsprechend des Meßaufbaues in tolerierbaren Grenzen gehalten werden. Dies wird insbesondere dadurch erreicht, daß das Elektro- und Magnetfeld an einem Punkt gleichzeitig erfaßt wird. Weiterhin werden möglichst kleine Sensoren zur Vermeidung von Fehlern durch Feldinhomogenitäten verwendet. Weiter haben möglichst kleine Sensoren den Vorteil, daß eine Mittelung bei der Messung eines elektrischen oder magnetischen Feldes vermieden wird. Darüber hinaus ist eine Annäherung an das zu vermessende Objekt möglich.

Mit der Erfindung werden insbesondere durch den Einsatz von empfindlichen Sensoren die für in der EMVU geltenden Maßstäbe erfüllt.

Die gleichzeitige dreidimensionale Erfassung von Elektround Magnetfeld vermeidet ferner mögliche Meßfehler bei der Suche nach dem maximalen Feld, die bei einer eindimensionalen Messung auftreten können.

Durch einen größeren Abstand zwischen der messenden Person und der Meßvorrichtung sowie durch technische Maßnahmen an der Meßvorrichtung zur Schaffung eines hochohmigen Aufbaus sowie von kleiner Kapazität zwischen Sensor und Anzeigeeinheit wird die Genauigkeit der Messung insbesondere des Elektrofeldes verbessert.

Mit dem erfindungsgemäßen Verfahren ist die gleichzeitige Messung elektrischer und magnetischer Felder möglich. Bevorzugt wird beim Messen elektrischer Felder insbesondere dreidimensionaler elektrischer Felder die Meßvorrichtung von der messenden Person in der Hand gehalten. Zur Messung elektrischer und/oder magnetischer Felder wird besonders bevorzugt die Vorrichtung mit Hilfe eines kurzen Halters, beispielsweise eines Stabes vom Körper entfernt getragen. Die erfindungsgemäße Vorrichtung und das Verfahren hat den Vorteil, daß eine messende Person sich mit der Vorrichtung in einem Raum oder im Freien bei der Messung bewegen kann, wobei auch bei vorhandenen hohen statischen Feldern von mehreren kV/m des Elektrofeldes genaue Messungen möglich sind. Vorzugsweise wird dabei der Sensor ruhig und gleichmäßig bewegt, wodurch statische Felder bei der Messung nicht stören.

Weitere Merkmale der Erfindung sind in den abhängigen Ansprüchen angegeben.

In der Zeichnung ist die Erfindung anhand von Ausführungsbeispielen veranschaulicht. Dabei zeigen:
- Fig. 1: eine schematische Darstellung eines dreidimensionalen Feldsensors, mit drei Spulen und sechs Kondensator-Platten,
- Fig. 2: eine schematische Anordnung von sechs Kondensator-platten,
- Fig. 3: eine Anordnung von zwölf Kondensatorplatten, und
- Fig. 4: ein Blockschaltbild einer Vorrichtung zur Messung elektrischer und/oder magnetischer Felder.

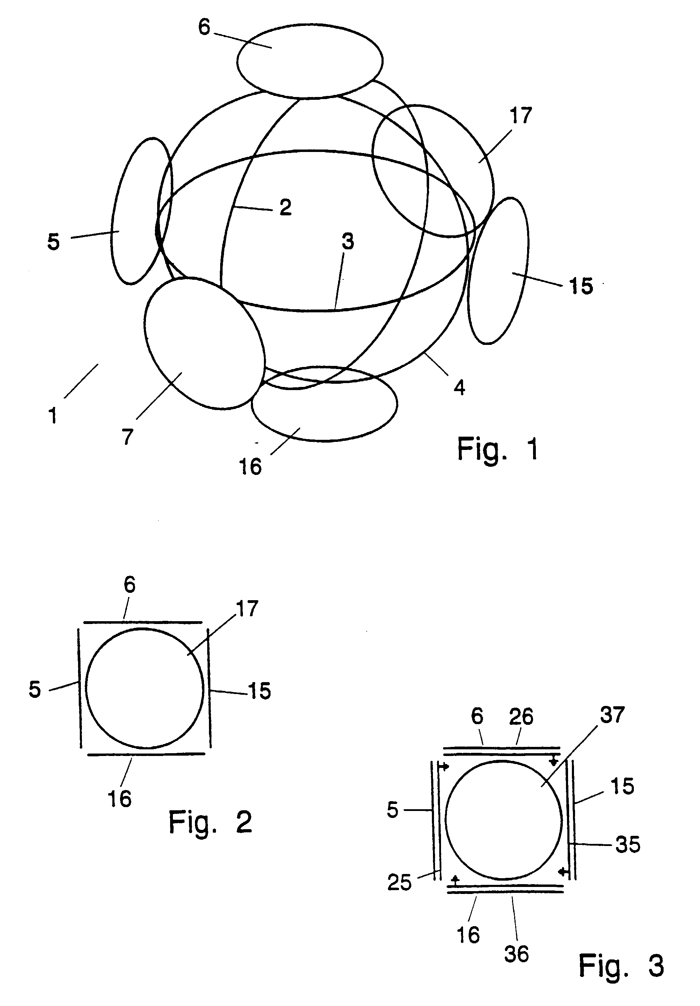

Mit 1 ist in Fig. 1 ein Feldsensor bezeichnet, der drei ineinanderliegende, kreisringförmige Spulen 2, 3 und 4 aufweist, von denen die Spule 2 in der X-Achse, die Spule 3 in der Y-Achse und die Spule 4 in der Z-Achse liegt. Außerhalb des durch die drei Spulen gebildeten kugelförmigen Gebildes sind sechs Kondensatorplatten 5, 15; 6, 16 und 7, 17 angeordnet, von denen jeweils zwei parallel zueinander angeordnet sind und einen Kondensator bilden. Die Kondensatorplatten 5, 15 sind dabei der X-Achse zugeordnet, der Kondensator mit den Platten 6, 16 der Y-Achse und die Kondensatorplatten 7, 17 der Z-Achse.

Die drei Spulen 2, 3, 4 dienen der dreidimensionalen Messung eines Magnetfeldes, während die drei Kondensatoren 5, 15; 6, 16 und 7, 17 der Messung des elektrischen Feldes dienen.

Zweckmäßigerweise sind die Kondensatorplatten so groß ausgebildet, daß sie einen nahezu geschlossenen Würfel bilden, wie dies in Fig. 2 dargestellt ist. Die Kondensatorplatten sind dabei kreisförmig ausgebildet und decken die im Inneren angeordneten Spulen 2, 3, 4 vollständig ab.

Beim Ausführungsbeispiel nach Fig. 3 sind jeweils zwei übereinander liegende Kondensatorplatten 5, 25; 6, 26, 7, 27, 15, 35; 16, 36; 17, 37 vorgesehen, die einen geringen Abstand voneinander aufweisen. Die jeweils innere Platte 25, 26, 27, 35, 36, 37 ist an die gemeinsame Masse angeschlossen, wobei sowohl die Masseanschlüsse als auch die Anschlüsse der anderen Platten an der Plattenaußenkante liegen, um eine Beeinträchtigung durch in den Anschlußleitungen fließende Ströme zu verhindern.

Die Oberflächen der Kondensatorplatten sind hochohmig beschichtet, es ist aber auch möglich, die Platten selbst aus einem Material mit hochohmiger Oberfläche herzustellen.

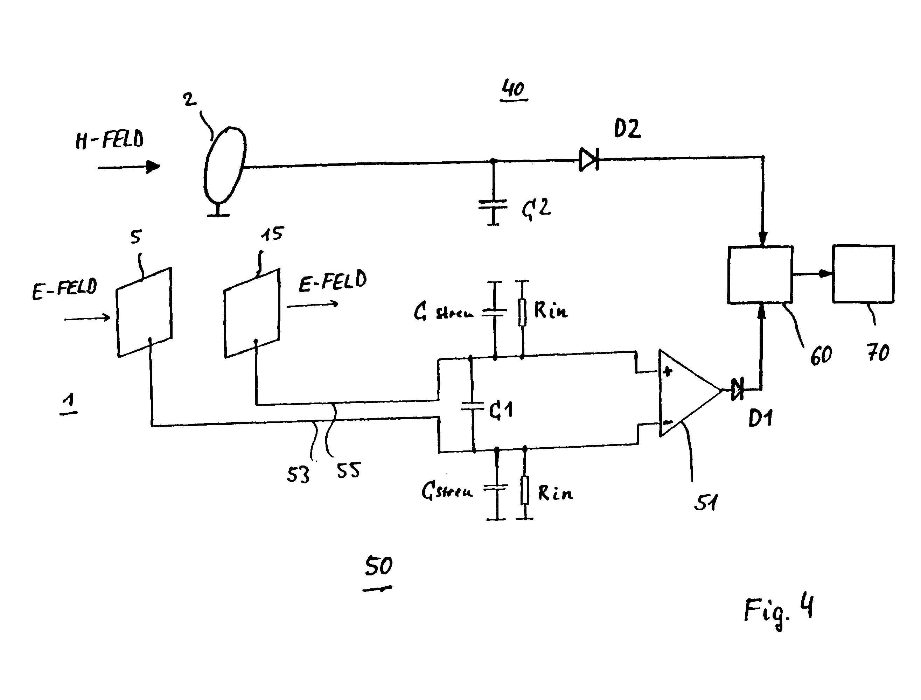

In Fig. 4 ist eine bevorzugte Ausführungsform einer Vorrichtung zur Messung elektrischer und magnetischer Felder als Prinzipschaltung gezeigt. Es ist schematisch ein Kondensatorplattenpaar 5, 15 zur eindimensionalen Messung eines elektrischen Feldes (E-Feld) und einer Spule 2 zur eindimensionalen Messung eines Magnetfeldes (H-Feld) gezeigt.

Die Vorrichtung 50 zur Messung eines elektrischen Feldes umfaßt einen Differenzverstärker 51, dessen nicht-invertierender Eingang mit der Kondensatorplatte 15 und dessen invertierender Eingang mit der Kondensatorplatte 5 verbunden ist. Zwischen den Eingängen des Differenzverstärkers 51 ist ein Kondensator C1 angeschlossen. Das Kondensatorplattenpaar 5, 15 und die Meßvorrichtung 50 sind über dünne Drähte 53, 55, die vorzugsweise miteinander verdrillt sind, verbunden. Beide Eingänge des Differenzverstärkers 51 weisen eine geringe Eingangskapazität CStreu auf, die vorzugsweise im Bereich zwischen 0,5 pF und 1 µF gegenüber Masse beträgt. Der Eingangswiderstand beider Eingänge Rin ist hochohmig mit Masse verbunden, wobei der Widerstand vorzugsweise 1 MΩ bis 100 TΩ. Die Kapazität des Kondensators C1 liegt vorzugsweise im Bereich von 0,5 pF bis 10 µF. Vorzugsweise ist die Kapazität umschaltbar von beispielsweise 1 nF auf 10 nF, wobei die Empfindlichkeit für unterschiedliche Meßbereiche geändert wird. Das Ausgangssignal des Differenzverstärkers 51 wird von einem Gleichrichter D1 gleichgerichtet und einer Auswerteeinrichtung 60 zugeführt.

In dem gezeigten Beispiel sind die Kondensatorplatten quadratisch und haben vorzugsweise eine Kantenlänge von 5 mm bis 300 mm. Der Abstand zwischen den Kondensatorplatten entspricht etwa der Kantenlänge der Kondensatorplatten. Der Abstand zwischen dem Feldsensor 1 und der Meßvorrichtung beträgt vorzugsweise 5 mm bis 1000 mm.

Bei Verwendung des Feldsensors, wie er in den Figuren 1 bis 3 dargestellt ist, wird jeweils ein Kondensatorplattenpaar mit einer zugehörigen Meßvorrichtung 50 verbunden. Auf diese Weise ist eine gleichzeitige dreidimensionale Erfassung des elektrischen Feldes möglich.

In dem gezeigten Beispiel bestehen die Kondensatorplatten aus einem hochohmigen Material wie Leiterplattenmaterial, FR4, Pertinax oder dgl. Auf der nach außen weisenden Kondensatorplatte ist jeweils eine leitfähige Schicht, z.B. aus Graphit aufgebracht. Die Verbindung der Drähte mit der zugehörigen Kondensatorplatte wird mit einem Leitlack bewirkt.

In einer alternativen Ausführungsform (nicht dargestellt) wird ein Würfel aus Kunststoff spritzgegossen, wobei jede der sechs Flächen eine Kondensatorplatte bildet. Dieser spritzgegossene Würfel ist hohl und beispielsweise als Box mit einem verschwenkbar angelenkten Deckel ausgebildet. In diese Box wird eine Anordnung aus drei zueinander senkrecht angeordneten Spulen 2, 3 und 4 (siehe Figuren 1, 2 und 3) eingesetzt. Vorzugsweise werden die Spulen mit den Kondensatorplatten durch Verkleben aneinander befestigt.

In Fig. 4 ist weiter eine Prinzipschaltung einer Vorrichtung zur Messung des magnetischen Feldes gezeigt, die einen mit einer Spule 2 verbundenen Integrator 40 aufweist. Der Integrator 40 besteht in dem gezeigten Ausführungsbeispiel aus einem Kondensator C2, der an Masse angeschlossen ist und einer Diode D2, die beide mit einem Ende der Spule 2 verbunden sind. Das andere Ende der Spule 2 ist an Masse angeschlossen. In dem gezeigten Beispiel hat die Spule eine ringförmige bzw. zylinderförmige Wicklung aus Drähten, wobei die Anzahl der Windungen zwischen 1 bis 50000 beträgt. Der Durchmesser der Spule ist in dem gezeigten Beispiel etwa 30 mm entsprechend der bevorzugten Kantenlänge der Kondensatorplatten 5, 15.

Die Meßvorrichtung weist ferner eine Auswerteeinrichtung 60 auf, an die das Ausgangssignal des Differenzverstärkers 51 und das Ausgangssignal des Integrators 40 angelegt wird. Von der Auswerteeinrichtung 60 werden die Ausgangssignale bearbeitet und skaliert an eine Anzeige 70 ausgegeben. Die Anzeige umfaßt vorzugsweise eine Balkendarstellung und gibt zusätzlich einen digitalen Zahlenwert aus. Die Anzeige weist ferner eine zuschaltbare akustische Anzeige auf, die vorzugsweise abhängig von der Stärke des Signals die Frequenz und/oder Lautstärke verändert, die einen Startwert und einen Endwert in einen entsprechenden Ton umsetzt. Dabei wird gleichzeitig eine parallele Auswertung der beiden Meßwerte vorgenommen.

Bei einer dreidimensionalen Messung eines elektrischen Feldes werden die Signale von den drei Kondensatorplattenpaaren 5, 15, 6, 16 und 7, 17 von drei Meßvorrichtungen 50 und die Signale der Spulen 2, 3, 4 von drei Meßvorrichtungen 40 erfaßt und an die Auswerteeinrichtung 60 angelegt. Die Auswerteeinrichtung umfaßt Analog/Digitalwandler, und einen Mikroprozessor, der die digitalen Signale weiter verarbeitet. Vorzugsweise werden die Ausgangssignale quadriert, anschließend die Summe der Quadrate gebildet und dann die Quadratwurzel der Summe berechnet. Außerdem erfolgt eine Skalierung. Das so ermittelte Ergebnis wird an die Anzeige 70 geliefert.

Ferner kann das Meßgerät über Lichtwellenleiter potentialfrei an ein entfernt angeordnetes Auswertegerät angeschlossen werden. Dabei ist das Meßgerät vorzugsweise fernbedienbar. Hiermit wird insbesondere eine vollständig potentialfreie Messung erreicht und Messungen ermöglicht bei vorhandenen hohen elektrischen oder magnetischen Feldern, ohne die messende Person diesen Feldern auszusetzen.

## Patentansprüche

1. Feldsensor (1) mit Einrichtungen zum Messen eines magnetischen Feldes und eines elektrischen Feldes, dadurch gekennzeichnet, daß wenigstens sechs Kondensatorplatten (5, 6, 7, 15, 16, 17, 25, 26, 27, 35, 36, 37) vorgesehen sind, welche würfelartig angeordnet sind, und daß in dem dadurch gebildeten Raum die Einrichtung zum Messen des magnetischen Feldes vorgesehen ist, die dreidimensional ausgerichtet ist und vorzugsweise aus Spulen (2, 3, 4), Halleffektsensoren oder Feldplatten besteht.

2. Feldsensor nach Anspruch 1, dadurch gekennzeichnet, daß drei ring- bzw. zylinderförmig gewickelte Spulen (2, 3, 4) vorgesehen sind, die jeweils senkrecht zueinander entlang der X-, Y- bzw. Z- Achse angeordnet sind, und daß die Spulen von den Kondensatorplatten (5, 6, 7, 15, 16, 17, 25, 26, 27, 35, 36, 37) umgeben sind, von denen jeweils zwei parallel zueinander angeordnet sind.

3. Feldsensor nach Anspruch 2, dadurch gekennzeichnet, daß die Spulen (2, 3, 4) ringförmig mit nahezu gleichem Durchmesser ineinander angeordnet sind.

4. Feldsensor nach Anspruch 2 oder 3, dadurch gekennzeichnet, daß jeweils einer Spule ein Kondensator-Plattenpaar zugeordnet ist, die parallel zur jeweiligen Spule außerhalb der Spulenanordnung vorgesehen sind.

5. Feldsensor nach einem der vorhergehenden Ansprüche, dadurch gekennzeichnet, daß die Kondensatorplatten (5 bis 37) mit einer hochohmigen Beschichtung versehen sind.

6. Feldsensor nach einem der Ansprüche 1 bis 4, dadurch gekennzeichnet, daß die Kondensatorplatten (5 bis 37) aus einem hochohmigen Material bestehen.

7. Feldsensor nach einem der vorhergehenden Ansprüche, dadurch gekennzeichnet, daß die Kondensatorpatten (5 bis 37) doppelt angeordnet sind, wobei die jeweils innere Platte (25 bis 37) elektrisch an einem gemeinsamen Massenanschluß liegt.

8. Feldsensor nach einem der vorhergehenden Ansprüche, dadurch gekennzeichnet, daß die elektrischen Anschlüsse an den Kondensatorplatten (5 bis 37) an deren Rand vorgesehen sind.

9. Vorrichtung zur Messung elektrischer Felder, gekennzeichnet durch
a) einen Feldsensor (1) nach einem der Ansprüche 1 bis 8 und
b) eine Meßvorrichtung (50) mit einem Differenzverstärker (51), mit einem nicht-invertierenden und einem invertierenden Eingang, wobei eine Kondensatorplatte (5 bis 37) mit dem nicht-invertierenden und die andere Kondensatorplatte (5 bis 37) mit dem invertierenden Eingang verbunden ist, und
einem Kondensator (C1) der mit einem Anschluß mit dem nicht-invertierenden Eingang und dem anderen Anschluß mit dem invertierenden Eingang des Differenzverstärkers (51) verbunden ist.

10. Vorrichtung nach Anspruch 9, wobei der Differenzverstärker (51) an seinem nicht-invertierenden und dem invertierenden Eingang jeweils mit kleiner Eingangskapazität gegen Masse entkoppelt ist, wobei die Eingangskapazität (CStreu) für beide Eingänge vorzugsweise gleich ist.

11. Vorrichtung nach Anspruch 10, wobei die Eingangskapazität (CStreu) der Eingänge des Differenzverstärkers (51) zwischen 0,5 pF und 1 µF beträgt.

12. Vorrichtung nach einem der Ansprüche 9 bis 11, wobei der nicht-invertierende Eingang und der invertierende Eingang des Differenzverstärkers (51) über einen hochohmigen Widerstand (Rin) mit Masse verbunden sind, wobei der Widerstand vorzugsweise 1 MΩ bis 100 TΩ beträgt.

13. Vorrichtung nach einem der Ansprüche 9 bis 12, wobei die Kapazität des Kondensators (C1) im Bereich von 0,5 pF bis 10 µF beträgt, vorzugsweise umschaltbar ist zwischen zwei Werten, vorzugsweise von 180 pF auf 1,8 nF.

14. Vorrichtung nach einem der Ansprüche 1 bis 13, wobei die Kondensatorplatten (5 bis 37) parallel zueinander angeordnet sind und vorzugsweise gleich groß sind.

15. Vorrichtung nach Anspruch 1 bis 14, wobei die Kondensatorplatten (5 bis 37) quadratisch sind und vorzugsweise eine Kantenlänge von 5 mm bis 300 mm haben.

16. Vorrichtung nach Anspruch 15, wobei ein Abstand zwischen dem zwei Kondensatorplatten (5 bis 37) im wesentlichen gleich der Kantenlänge der Kondensatorplatten ist.

17. Vorrichtung nach einem der Ansprüche 9 bis 16, wobei jedes Kondensator-Plattenpaar mit dem Differenzverstärker (51) über dünne Drähte (53, 55) verbunden sind, die vorzugsweise miteinander verdrillt sind und bevorzugt Drähtepaare voneinander beabstandet geführt werden.

18. Vorrichtung nach einem der Ansprüche 9 bis 17, wobie der Abstand zwischen dem Feldsensor (1) und dem Differenzverstärker zwischen 5 mm und 1000 mm beträgt.

19. Vorrichtung nach einem der Ansprüche 9 bis 18, wobei die Fläche des Differenzverstärkers (51) und/oder des Kondensators (C1) kleiner ist als die Fläche einer Kondensatorplatte.

20. Vorrichtung zur dreidimensionalen Messung elektrischer Felder, gekennzeichnet durch drei Vorrichtungen nach einem der Ansprüche 9 bis 19, wobei ein erstes Kondensatorplattenpaar das elektrische Feld in X-Richtung, ein zweites Kondensatorplattenpaar das elektrische Feld in Y-Richtung und ein drittes Kondensatorplattenpaar ein elektrisches Feld in Z-Richtung erfaßt.

21. Vorrichtung nach Anspruch 20, wobei die Kondensatorplatten quadratisch sind und der Abstand zwischen jeweils zwei Kanten von Kondensatorplatten von benachbarten Plattenpaaren 0,1 mm bis 50 mm, vorzugsweise 1 mm beträgt.

22. Vorrichtung nach einem der Ansprüche 1 bis 21, wobei die Kondensatorplatten aus eine Kunststoff, vorzugsweise einem Leiterplattenmaterial bestehen und auf einer Seite, die jeweils von der gegenüberliegenden Kondensatorplatte eines Plattenpaares abgewandt ist, mit einer leitfähigen Schicht, wie Graphitschicht versehen ist.

23. Vorrichtung nach einem der Ansprüche 17 bis 22, wobei jeder Draht mit einer zugehötigen Kondensatorplatte mit einem Leitlack vorzugsweise im Bereich einer Kante kontaktiert wird.

24. Vorrichtung nach einem der Ansprüche 1 bis 23, wobei ein Würfel vorzugsweise aus Kunstsoff wie Polyurethan spritzgegossen wird, wobei jede der sechs Flächen des Würfels eine Kondensatorplatte bildet.

25. Vorrichtung nach Anspruch 24, wobei der spritzgegossene Würfel hohl ist und vorzugsweise eine Box mit einem Decke bildet, der vorzugsweise entlang einer Würfelkante gelenkig angeordnet ist.

26. Vorrichtung zur Messung elektrischer und magnetischer Felder mit einem Feldsensor (1) nach einem der Ansprüche 1 bis 8 und einer Vorrichtung zur Messung elektrischer Felder nach einem der Ansprüche 9 bis 25, gekennzeichnet durch mindestens einen Integrator (40), der mit einer Spule (2, 3, 4) verbunden ist.

27. Vorrichtung an Anspruch 26, wobei der Integrator (40) einen mit einem Anschluß einer Spule (2, 3, 4) verbundenen Kondensator (C2) aufweist der an Masse angeschlossen ist und mit einem Gleichrichter (D2) verbunden ist, der ein Ausgangssignal liefert.

28. Vorrichtung einem der Ansprüche 9 bis 27, wobei ein Ausgangssignal einer Meßvorrichtung (50) und/oder eines Integrators (40) an eine Auswerteeinrichtung (60) geliefert wird, dessen Ergebnis an eine optische und/oder akustische Anzeige (70) zugeführt wird.

29. Vorrichtung nach Anspruch 28, wobei die Auswerteeinrichtung (60) bei einer dreidimensionalen Messung eines elektrischen Feldes die Ausgangssignale von jedem von drei Differenzverstärkern (51) zunächst quadriert, anschließend die Quadrate summiert und schließlich die Quadratwurzel der Summe bilder und an die Anzeige (70) liefert und/oder für eine dreidimensionale Messung eines magnetischen Feldes die Ausgangssignale von drei Integratoren (40) jeweils zunächst quadriert, anschließend die Quadrate summiert und schießlich die Quadratwurzel der Summe bildet und an die Anzeige (70) liefert.

30. Vorrichtung nach einem der Ansprüche 1 bis 29, wobei mehrere Spulen vorzugsweise mittels Kleben miteinander verbunden sind und die Kondensatorplatten mit der jeweils zugehörigen Spule mittels Kleben damit verbunden werden.

31. Vorrichtung nach einem der Ansprüche 1 bis 30, wobei der Raum im Bereich der Spulen und im Bereich zwischen den Kondensatorplatten mit einem Kunststoffschaum, wie Polyurethan, Polystyrol oder dgl. mindestens teilweise ausgefüllt wird.

32. Verwendung eines Sensors nach einem der Ansprüche 1 bis 8 und einer Vorrichtung nach einem der Ansprüche 9 bis 31 zum dreidimensionalen Messen eines elektrischen Feldes und gleichzeitig zum dreidimensionalen Messen eines magnetischen Feldes.

33. Verwendung nach Anspruch 32, dadurch gekennzeichnet, daß die Vorrichtung zum Messen elektrischer Felder, insbesondere zum dreidimensionalen Messen, während der Messung in der Hand einer messenden Person gehalten wird.

34. Verwendung nach Anspruch 32 oder 33, dadurch gekennzeichnet, daß zum Messen elektrischer und/oder magnetischer Felder die Vorrichtung mittels eines kurzen Halters von einer messenden Person gehalten wird.

35. Verwendung eines Sensors nach einem der Ansprüche 1 bis 8 und einer Vorrichtung nach einem der Ansprüche 9 bis 31 zum Messen elektrischer Felder, vorzugsweise im niederfrequenten Bereich, gekennzeichnet durch langsames und ruhiges Führen der Vorrichtung, wobei Meßfehler durch statische Elektrogleichfelder minimiert werden, die durch Bewegungen der Vorrichtung sonst als Wechselfelder detektiert werden.

## Claims

1. A field sensor (1) comprising means for measuring a magnetic field and an electric field, characterized in that at least six capacitor plates (5, 6, 7, 15, 16, 17, 25, 26, 27, 35, 36, 37) are provided, which are arranged in a cube, and in that the means for measuring the magnetic field is provided in the thus formed space, which means is three-dimensionally aligned and preferably consists of coils (2, 3, 4), Hall-effect sensors or magnetoresistors.

2. The field sensor according to claim 1, characterized in that three coils (2, 3, 4) wound annularly or cylindrically are provided, which are arranged perpendicularly to each other along the x-, y- or z-axis, respectively, and in that the coils are surrounded by said capacitor plates (5, 6, 7, 15, 16, 17, 25, 26, 27, 35, 36, 37) every two of which are arranged in parallel to each other.

3. The field sensor according to claim 2, characterized in that the coils (2, 3, 4) are annularly fitted into each other with an almost identical diameter.

4. The field sensor according to claim 2 or 3, characterized in that each coil is assigned to a couple of capacitor plates which are provided in parallel to the respective coil outside the coil arrangement.

5. The field sensor according to any one of the previous claims, characterized in that the capacitor plates (5 to 37) are provided with a high-resistance coating.

6. The field sensor according to any one of claims 1 to 4, characterized in that the capacitor plates (5 to 37) consist of a high-resistance material.

7. The field sensor according to any one of the previous claims, characterized in that the capacitor plates (5 to 37) are arranged in couples, wherein each of the respective inner plates (25 to 37) is electrically connected to a common earth terminal.

8. The field sensor according to any one of the previous claims, characterized in that the electric lines of the capacitor plates (5 to 37) are provided at their edges.

9. A device for measuring electric fields, characterized by
(a) a field sensor (1) according to any one of claims 1 to 8, and
(b) a measuring device (50) with a differential amplifier (51), comprising a non-inverting and an inverting input, wherein one capacitor plate (5 to 37) is connected with the non-inverting and the other capacitor plate (5 to 37) with the inverting input, and
a capacitor (C1) one terminal of which is connected with the non-inverting input and the other terminal with the inverting input of the differential amplifier (51).

10. The device according to claim 9, wherein the differential amplifier (51) is decoupled to earth both at its non-inverting and inverting inputs with a small input capacity, the input capacity (Cstray) being preferably identical for both inputs.

11. The device according to claim 10, wherein the input capacity (Cstray) of the inputs of the differential amplifier (51) is between 0.5 pF and 1 µF.

12. The device according to any of claims 9 to 11, wherein the non-inverting input and the inverting input of the differential amplifier (51) are connected via a high-ohmic resistance (Rin) to earth, the resistance ranging preferably from 1 MΩ to 100 TΩ.

13. The device according to any one of claims 9 to 12, wherein the capacity of the capacitor (C1) is in the range of 0.5 pF to 10 µF and is preferably switchable between two values, preferably from 180 pF to 1.8 nF.

14. The device according to any one of claims 1 to 13, wherein the capacitor plates (5 to 37) are arranged in parallel to each other and preferably have the same size.

15. The device according to claims 1 to 14, wherein the capacitor plates (5 to 37) are square and preferably have an edge length of 5 mm to 300 mm.

16. The device according to claim 15, wherein the distance between the two capacitor plates (5 to 37) is substantially identical to the edge length of the capacitor plates.

17. The device according to any one of claims 9 to 16, wherein each of the capacitor-plate couples is connected with the differential amplifier (51) via thin wires (53, 55) which are preferably twisted, and wherein preferably wire couples are spaced apart from each other.

18. The device according to any one of claims 9 to 17, wherein the distance between the field sensor (1) and the differential amplifier is between 5 mm and 1000 mm.

19. The device according to any one of claims 9 to 18, wherein the surface of the differential amplifier (51) and/or the capacitor (C1) is smaller than the surface of a capacitor plate.

20. A device for three-dimensionally measuring electric fields, characterized by three devices according to any one of claims 9 to 19, wherein a first capacitor-plate couple measures the electric field in the direction of the x-axis, a second capacitor-plate couple measures the electric field in the direction of the y-axis and a third capacitor-plate couple measures an electric field in the direction of the z-axis.

21. The device according to claim 20, wherein the capacitor plates are square and the distance between each two edges of capacitor plates of adjacent plate couples is 0.1 mm to 50 mm, preferably 1 mm.

22. The device according to any one of claims 1 to 21, wherein the capacitor plates consist of plastics, preferably a printed circuit material, and are provided with a conductive layer, such as a graphite layer, on a side facing away from the opposing capacitor plate of a plate couple.

23. The device according to any one of claims 17 to 22, wherein each wire is contacted with an associated capacitor plate comprising a conductive lacquer/varnish preferably in the area of an edge.

24. The device according to any one of claims 1 to 23, wherein a cube preferably of plastics such as polyurethane is injection-moulded, each of the six faces of the cube forming a capacitor plate.

25. The device according to claim 24, wherein the injection-moulded cube is hollow and preferably forms a box with a lid, which is preferably hingedly arranged along a cube edge.

26. A device for measuring electric and magnetic fields, comprising a field sensor (1) according to any one of claims 1 to 8 and a device for measuring electric fields according to any one of claims 9 to 25, characterized by at least one integrator (40) connected to a coil (2, 3, 4).

27. The device according to claim 26, wherein the integrator (40) comprises a capacitor (C2) which is connected with a terminal of a coil (2, 3, 4) and which is connected to earth and with a rectifier (D2) supplying an output signal.

28. The device according to any one of claims 9 to 27, wherein an output signal of a measuring device (50) and/or an integrator (40) is supplied to an evaluation means (60) whose result is supplied to an optical and/or acoustic display (70).

29. The device according to claim 28, wherein during a three-dimensional measurement of an electric field the evaluation means (60) first squares the output signals of each of three differential amplifiers (51), subsequently adds the squares and eventually takes the square root of the sum and supplies it to the display (70) and/or for a three-dimensional measurement of a magnetic field first squares each output signal of three integrators (40), subsequently adds the squares and eventually takes the square root of the sum and supplies it to the display (70).

30. The device according to any of claims 1 to 29, wherein several coils are connected preferably by gluing and the capacitor plates are connected with the respectively associated coil by gluing.

31. The device according to any one of claims 1 to 30, wherein the space in the coil area and in the area between the capacitor plates is at least partially filled up with a plastics foam, such as polyurethane, polystyrene or the like.

32. Use of a sensor according to any one of claims 1 to 8 and a device according to any one of claims 9 to 31 for measuring an electric field three-dimensionally and simultaneously for measuring a magnetic field three-dimensionally.

33. The use according to claim 32, characterized in that the device for measuring electric fields, in particular for measuring three-dimensionally, is held during the measurement in the hand of a person taking the measurement.

34. The use according to claim 32 or 33, characterized in that for measuring electric and/or magnetic fields the device is held by means of a short handle by a person taking the measurement.

35. Use of a sensor according to any one of claims 1 to 8 and a device according to any one of claims 9 to 31 for measuring electric fields, preferably in the low-frequency range, characterized by slow and calm movements of the device, wherein measuring errors by static continuous fields, which by movements of the device are otherwise detected as alternating fields, are minimized.

## Revendications

1. Capteur de champ (1) comportant des dispositifs pour mesurer un champ magnétique et un champ électrique, caractérisisé par le fait qu'il est prévu au moins six plaques de condensateur (5, 6, 7, 15, 16, 17, 25, 26, 27, 35, 36, 37) qui sont disposées de manière à former un cube et par le fait que le dispositif de mesure du champ magnétique est disposé dans l'espace ainsi formé, lequel dispositif est de type tridimensionnel et est formé de préférence de bobines (2, 3, 4), de transistors à effet de champ ou de plaques de champ.

2. Capteur de champ selon la revendication 1, caractérisé par le fait qu'il est prévu trois bobines (2, 3, 4) annulaires ou cylindriques qui sont disposées à angle droit les unes par rapport aux autres suivant les axes X, Y et Z et par le fait que les bobines sont entourées des plaques de condensateur (5, 6, 7, 15, 16, 17, 25, 26, 27, 35, 36, 37) qui sont chaque fois parallèles deux à deux.

3. Capteur de champ selon la revendication 2, caractérisé par le fait que les bobines (2, 3, 4) annulaires de diamètre sensiblement égal sont disposées l'une dans l'autre.

4. Capteur de champ selon la revendication 2 ou 3, caractérisé par le fait qu'à chaque bobine est associée une paire de plaques de condensateur qui sont disposées parallèlement à la bobine concernée à l'extérieur du système de bobines.

5. Capteur de champ selon une des revendications 1 à 4, caractérisé par le fait que les plaques de condensateur (5 à 37) sont pourvues d'un revêtement à forte résistance ohmique.

6. Capteur de champ selon une des revendications 1 à 4, caractérisé par le fait que les plaques de condensateur (5 à 37) sont constituées d'un matériau à forte résistance ohmique.

7. Capteur de champ selon une des revendications précédentes, caractérisé par le fait que les plaques de condensateur (5 à 37) sont prévues en double, la plaque intérieure (25 à 37) étant connectée électriquement à une borne de masse commune.

8. Capteur de champ selon une des revendications précédentes, caractérisé par le fait que les connexions électriques sur les plaques de condensateur (5 à 37) sont prévues sur le bord de celles-ci

9. Dispositif pour la mesure de champs électriques, caractérisé par
a) un capteur de champ (1) selon une des revendications 1 à 8 et
b) un dispositif de mesure (50) comportant un amplificateur différentiel (51), avec une entrée non-inverseuse et une entrée inverseuse, une plaque de condensateur (5 à 37) étant connectée à l'entrée non-inverseuse et l'autre plaque de condensateur (5 à 37) étant connectée à l'entrée inverseuse et
un condensateur (C1) qui est connecté par une borne à l'entrée non-inverseuse et par l'autre borne à l'entrée inverseuse de l'amplificateur différentiel (51).

10. Dispositif selon la revendication 9, dans lequel l'amplificateur différentiel (51) au niveau de son entrée non-inverseuse et de son entrée inverseuse est découplé par rapport à la masse au moyen d'une petite capacité d'entrée, la capacité d'entrée (CStreu) étant de préférence identique pour les deux entrées.

11. Dispositif selon la revendication 10, dans lequel la capacité d'entrée (CStreu) des entrées de l'amplificateur différentiel (51) est comprise entre 0,5 pF et 1 µF.

12. Dispositif selon une des revendications 9 à 11, dans lequel l'entrée non-inverseuse et l'entrée inverseuse de l'amplificateur différentiel (51) sont reliées à la masse par l'intermédiaire d'une résistance (Rin) à forte valeur ohmique, la résistance étant comprise de préférence entre 1 MΩ et 100 TΩ.

13. Dispositif selon une des revendications 9 à 12, dans lequel la capacité du condensateur (CI) est comprise dans une plage allant de 0,5 pF à 10 µF, de préférence est commutable entre deux valeurs, de préférence entre 180 pF et 1,8 nF.

14. Dispositif selon une des revendications 1 à 13, dans lequel les plaques de condensateur (5 à 37) sont disposées parallèlement l'une à l'autre et de préférence sont de même dimension.

15. Dispositif selon une des revendications 1 à 14, dans lequel les plaques de condensateur (5 à 37) sont carrées et de préférence ont une longueur de côté comprise entre 5 mm et 300 mm.

16. Dispositif selon la revendication 15, dans lequel la distance entre deux plaques de condensateur (5 à 37) est sensiblement égale à la longueur de côté des plaques de condensateur.

17. Dispositif selon une des revendications 9 à 16, dans lequel chaque paire de plaques de condensateur est connectée à l'amplificateur différentiel (51) par l'intermédiaire de fils fins (53, 55) qui, de préférence, sont torsadés, et de préférence les paires de fils sont disposées à distance les unes des autres.

18. Dispositif selon une des revendications 9 à 17, dans lequel la distance entre le capteur de champ (1) et l'amplificateur différentiel est comprise entre 5 mm et 1000 mm.

19. Dispositif selon une des revendications 9 à 18, dans lequel la surface de l'amplificateur différentiel (51) et/ou du condensateur (C1) est inférieure à la surface d'une plaque de condensateur.

20. Dispositif pour la mesure tridimensionnelle de champs électriques, caractérisé par trois dispositifs selon une des revendications 9 à 19, dans lequel une première paire de plaques de condensateur mesure le champ électrique dans la direction X, une deuxième paire de plaques de condensateur mesure le champ électrique dans la direction Y et une troisième paire de plaques de condensateur mesure le champ électrique dans la direction Z.

21. Dispositif selon la revendication 20, dans lequel les plaques de condensateur sont carrées et la distance entre deux bords de plaques de condensateur de paires de plaques voisines est de 0,1 mm à 50 mm, de préférence est de 1 mm.

22. Dispositif selon une des revendications 1 à 21, dans lequel les plaques de condensateur sont formées d'une matière plastique, de préférence d'un matériau à circuits imprimés, et sont pourvues, sur une face qui est éloignée de la plaque de condensateur en vis-à-vis de la paire de plaques, d'une couche conductrice telle qu'une couche de graphite.

23. Dispositif selon une des revendications 17 à 22, dans lequel chaque fil est en contact avec une plaque de condensateur concernée pourvue d'un vernis conducteur, de préférence dans la région d'un bord.

24. Dispositif selon une des revendications 1 à 23, dans lequel un cube de préférence en une matière plastique telle que du polyuréthane est moulé par injection, chacune des six faces du cube formant une plaque de condensateur.

25. Dispositif selon la revendication 24, dans lequel le cube moulé par injection est creux et de préférence forme une boîte avec un couvercle qui de préférence est articulé le long d'une arête du cube.

26. Dispositif pour la mesure de champs électriques et magnétiques comprenant un capteur de champ (1) selon une des revendications 1 à 8, et un dispositif pour la mesure de champs électriques selon une des revendications 9 à 25, caractérisé par au moins un intégrateur (40), qui est connecté à une bobine (2, 3, 4).

27. Dispositif selon la revendication 26, dans lequel l'intégrateur (40) comporte un condensateur (C2) relié à une borne d'une bobine (2, 3, 4) qui est connecté à la masse et à un redresseur (D2) qui délivre un signal de sortie.

28. Dispositif selon une des revendications 9 à 27, dans lequel un signal de sortie d'un dispositif de mesure (50) et/ou d'un intégrateur (40) est délivré à un dispositif de traitement (60), dont le résultat est transmis à un moyen d'affichage (70) optique et/ou acoustique.

29. Dispositif selon la revendication 28, dans lequel le dispositif de traitement (60), dans le cas d'une mesure tridimensionnelle d'un champ électrique, élève au carré les signaux de sortie de chacun des amplificateurs différentiels (51), forme la somme des carrés et enfin calcule la racine carrée de la somme et délivre celle-ci au moyen d'affichage (70) et dans le cas d'une mesure tridimensionnelle d'un champ magnétique élève au carré les signaux de sortie de trois intégrateurs (40), calcule la somme des carrés et enfin forme la racine carrée de la somme et délivre celle-ci au moyen d'affichage (70).

30. Dispositif selon une des revendications 1 à 29, dans lequel plusieurs bobines sont liées les unes aux autres, de préférence par collage, et les plaques de condensateur sont liées par collage à la bobine concernée.

31. Dispositif selon une des revendications 1 à 30, dans lequel l'espace dans la région des bobines et dans la région entre les plaques de condensateur est au moins partiellement rempli d'une matière plastique expansée, par exemple de polyuréthane, de polystyrène ou similaire.

32. Utilisation d'un capteur selon une des revendications 1 à 8 et d'un dispositif selon une des revendications 9 à 31 pour la mesure tridimensionnelle d'un champ électrique et simultanément pour la mesure d'un champ magnétique.

33. Utilisation selon la revendication 32, caractérisée par le fait que le dispositif pour la mesure de champs électriques, en particulier pour la mesure tridimensionnelle de champs électriques, pendant la mesure, est tenu dans la main par la personne qui effectue la mesure.

34. Utilisation selon la revendication 32 ou 33, caractérisée par le fait que pour la mesure de champs électriques et/ou magnétiques, le dispositif est tenu , au moyen d'un court support, par la personne qui effectue la mesure.

35. Utilisation d'un capteur selon une des revendications 1 à 8 et d'un dispositif selon une des revendications 9 à 31, pour la mesure de champs électriques, de préférence dans le domaine des fréquences basses, caractérisée par un déplacement lent et sans à-coup du dispositif, les erreurs de mesure dues à des champs électriques continus statiques qui sans quoi, avec le déplacement du dispositif, seraient détectées comme des champs alternatifs, étant minimisées.
